# EUROPEAN PATENT SPECIFICATION

(11) **EP 1 665 910 B1**
(45) Date of publication and mention of the grant of the patent: **28.03.2007**
(21) Application number: 04778206.5
(22) Date of filing: 14.07.2004
(51) Int. Cl.: H05K 1/00

(54) **MECHANISM FOR DISABLING AN ELECTRONIC ASSEMBLY**
MECHANISMUS ZUR SPERRUNG EINER ELEKTRONISCHEN BAUGRUPPE
MECANISME POUR DESACTIVER UN ASSEMBLAGE ELECTRONIQUE

(30) Priority: 19.09.2003 US 667115
(43) Date of publication of application: 07.06.2006
(73) Proprietor: SUN MICROSYSTEMS, INC., San Jose, CA 95054 (US)
(72) Inventor: MIROV, Russell, Norman, Los Altos, CA 94024 (US)
(74) Representative: Davies, Simon Robert
(86) International application number: PCT/US2004/022576
(87) International publication number: WO 2005/036937

(56) References cited:
- EP-A- 0 223 715
- EP-A- 0 344 524
- EP-A- 1 233 661
- DE-A- 19 927 795
- DE-A1- 4 340 260
- DE-A1- 10 221 086
- FR-A- 2 832 286
- JP-A- 7 240 537
- US-A1- 2003 173 109
- C.D.HENDREN AND W.S. YOUNG: "Electronic Keyboard Module Housing. September 1978." IBM TECHNICAL DISCLOSURE BULLETIN, vol. 21, no. 4, 1 September 1978 (1978-09-01), page 1538, XP002306350 New York, US
- D.R.ANDREWS ET AL: "Copier Access Control Feature with Internal Billing Data. June 1981." IBM TECHNICAL DISCLOSURE BULLETIN, vol. 24, no. 1B, 1 June 1981 (1981-06-01), pages 816-818, XP002325134 New York, US

## Description

### BACKGROUND

This invention relates to the field of electronics. More particularly, a mechanism is provided for disabling an electronic assembly or component.

Manufacturers and vendors of electronic assemblies (e.g., computer motherboards, circuit boards) often wish to dispose of an assembly if it is broken or defective in some manner, is obsolete or is otherwise no longer usable or otherwise needed. Manufacturers often contract with third parties for disposal of such assemblies.

However, it is not uncommon for assemblies that a manufacturer or vendor releases for disposal to end up back in circulation. For example, an assembly previously sent for disposal may be returned to its manufacturer as defective, in the hope of receiving a refund, or may be presented to a vendor as a functional item. The manufacturer or vendor may thus end up paying for the fraudulent or accidental failure to properly dispose of the assembly.

Thus, what is needed is a mechanism or manner of disabling an electronic assembly or component so that its destruction can be assured and/or it cannot be passed off as a functional unit.

DE 19927795-A1 discloses a circuit board with a switch facility. A first component on the circuit board is connected to other components by one or more breakable conductors. The circuit board is arranged so that the portion of the circuit board including the first component can be broken away from the rest of the circuit board using a handle, thereby breaking the connectivity between the different components.

### SUMMARY

Accordingly, the present invention provides an apparatus and method as defined in the appended claims

In one embodiment, a mechanism for provably disabling an electronic assembly such as a circuit board comprises a tab or key that is normally attached to the assembly during operation. The key may comprise a portion of the assembly itself. If and when the key is detached, the assembly is prevented from being fully functional.

In this embodiment, the key also comprises a wire trace, optical conduit or other signal conductor that is severed or altered when the key is detached from the assembly. The assembly may fail to power up if the conductor is altered (e.g., broken). Or, a processing element on the assembly may detect the broken conductor and disable some or all functionality of the assembly or simply report the absence of the key.

In an embodiment of the invention, the key may include some form of identification. The identification may comprise a hologram, a barcode, a serial number or other sequence of alphanumeric characters, an electronic identification chip, etc.

Removal of the key and proper disposal of the assembly may be evidenced by the detached key or through manual or automated visual inspection of the assembly.

### DESCRIPTION OF THE FIGURES

FIG. 1 is a block diagram depicting a mechanism for disabling an electronic assembly, in accordance with one embodiment of the present invention.
FIG. 2 is a block diagram of a mechanism for provably disabling an electronic assembly, in accordance with one embodiment of the invention.
FIG. 3 depicts another mechanism for disabling an electronic assembly, in accordance with another embodiment of the present invention.
FIG. 4 depicts yet another mechanism for disabling an electronic assembly, in accordance with another embodiment of the present invention.

### DETAILED DESCRIPTION

The following description is presented to enable any person skilled in the art to make and use the invention, and is provided in the context of particular applications of the invention and their requirements. Various modifications to the disclosed embodiments will be readily apparent to those skilled in the art and the general principles defined herein may be applied to other embodiments and applications without departing from the scope of the present invention. Thus, the present invention is not intended to be limited to the embodiments shown, but is to be accorded the widest scope consistent with the principles and features disclosed herein.

In one embodiment of the invention, a mechanism is provided for ensuring an electronic assembly is disabled. The mechanism may be used in a method of proving an assembly has been disabled, or in a method of determining whether an assembly has been disabled. The electronic assembly may be a circuit board, processor board or other assembly comprising electronic components, and may be designed for use in a computer or other electronic device.

In an embodiment of the invention, the mechanism comprises a portion of an electronic assembly that can be detached from the assembly. More particularly, the mechanism may comprise a tab or other protuberance. The mechanism also comprises a signal conduit (e.g., a wire trace) that is severed when the mechanism is detached. When the conduit is severed, the assembly becomes fully or partially non-functional. Illustratively, the signal conduit may be laid on an inner layer of a multi-layer assembly board. This may make it more difficult for a third party to manipulate the conduit.

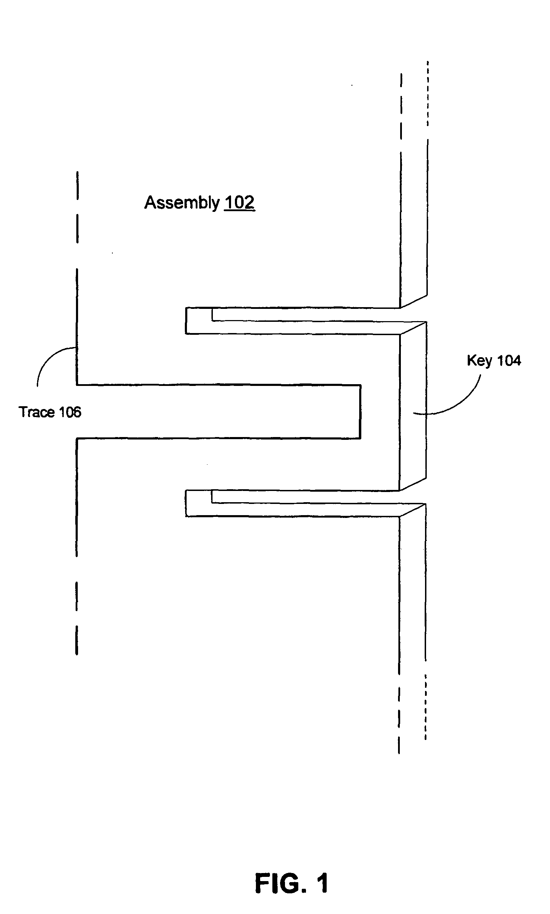

FIG. 1 is a block diagram of a mechanism for disabling an electronic assembly, according to one embodiment of the invention. Assembly 102 may be a motherboard or other assembly installable in a computer system. Assembly 102 comprises tab or key 104 and trace 106.

Trace 106 is coupled to a processor or other integrated circuit that is programmed to test whether the trace is intact, and/or make some or all operations of the assembly non-functional when the trace is broken. Alternatively, trace 106 could be part of a power circuit for the assembly. Trace 106 may be a metallic or optical signal conduit.

The dimensions and configuration (e.g., shape) of key 104 may vary greatly among different embodiments of the invention. For example, the thicker the assembly (e.g., the assembly substrate), the greater the surface area of the key may be to facilitate its removal.

In another embodiment of the invention, some form of identification may be included on a key, and may be used as evidence that the assembly was made non-functional. For example, the key may include a barcode, a hologram, an etched identification string, an electronic identification chip, etc. A company or other entity charge with disposing of an assembly that includes such a key may proffer the key as evidence of the assembly's proper disposal. Further, by matching key identifications of assemblies it receives against those sent for disposal, a manufacturer or vendor can determine if an assembly has been improperly recycled.

A key identification may be encapsulated (e.g., in epoxy) to make it difficult to remove without destroying the identification. Other forms of identification (e.g., a barcode, a hologram) may be configured to shred if an attempt is made to remove or tamper with them.

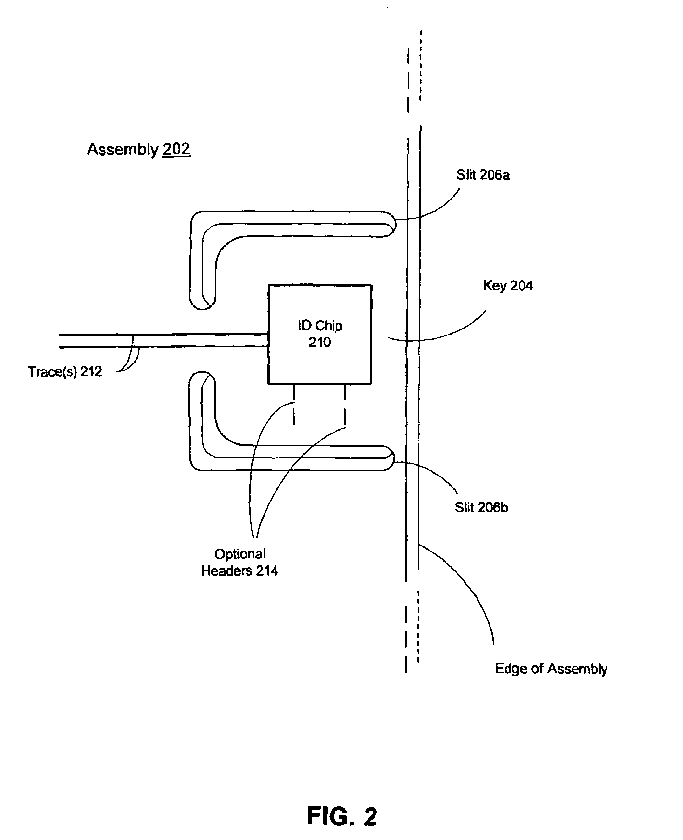

FIG. 2 is a block diagram of another mechanism for provably disabling an electronic assembly, according to one embodiment of the invention in which the mechanism includes an identification code.

In FIG. 2, assembly 202 includes key mechanism 204, which is partially defined by slits 206. The slits facilitate separation of the key from the assembly. In other embodiments of the invention, removal of the key may be facilitated by one or more slits, slots, gaps, channels, bores or other spaces aligned about the key, or between the key and the remainder of the electronic assembly. The spaces may be arranged in any configuration (e.g., horizontal, vertical, diagonal, irregular), and may be of any number. In another embodiment of the invention, separation of a key from an assembly may be facilitated by weakened or thinner substrate at a boundary of the key (i.e., instead of, or in addition to, a gap).

Key 204 may be composed partially or fully of the same material as the assembly, or of different material.

Although key 204 is situated at an internal or external edge of assembly 202, it could be located at a distance from an edge, could be aligned at an angle to the main surface of the assembly, or in some other orientation. In other words, key 204 is shown being coplanar with assembly 202 in FIG. 2. However, in other embodiments of the invention, they need not be coplanar.

Key 204 includes ID chip 210, on which an identification number or code is permanently encoded or programmed. Chip 210 may comprise a preprogrammed identification module (e.g., a PROM or EPROM) offered by Dallas Semiconductor, Maxim Integrated Products or some other manufacturer. ID chip 210 may be encapsulated to prevent its removal and installation on a different assembly. Illustratively, the identification code may be unique and complex (e.g., long), and may be laser encoded, to prevent it from being easily cloned.

Trace(s) 212 lead to/from key 204 and/or ID chip 210. If a trace 212 is broken, assembly 202 becomes partly or fully non-functional.

Optional headers 214 allow the identification to be read on-line and/or off-line, so that the identification code may be readable after key 204 is detached from the assembly. In one embodiment of the invention, the identification can only be read after the key is detached from the assembly (e.g., after trace 212 is broken). An entity charged with destroying assembly 202 could demonstrate its proper disposal by reading and reporting the identification code from the chip. Headers 214 may comprise virtually any form of signal connector, such as edge finger pads, header posts, etc.

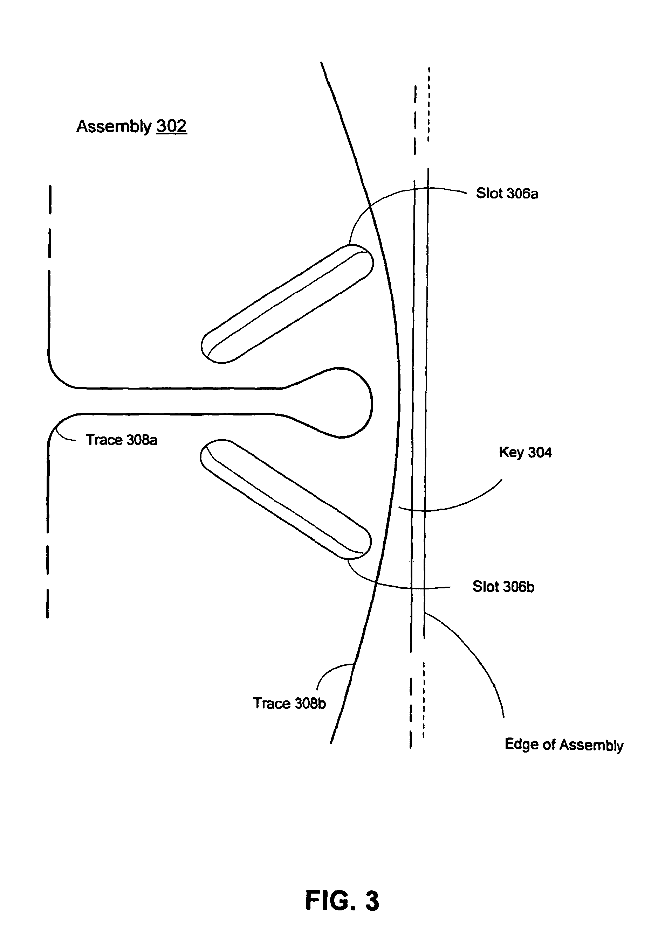

FIGs. 3-4 demonstrate alternative configurations of a mechanism for disabling an electronic assembly, according to other embodiments of the invention.

In FIG. 3, one or more slots 306 are arranged to facilitate detachment of key 304 from assembly 302. The slots may be of any dimensions. Traces 308a, 308b demonstrate different possible configurations of a trace for disabling the assembly when the key is detached. Either or both of them, and/or others, may be employed.

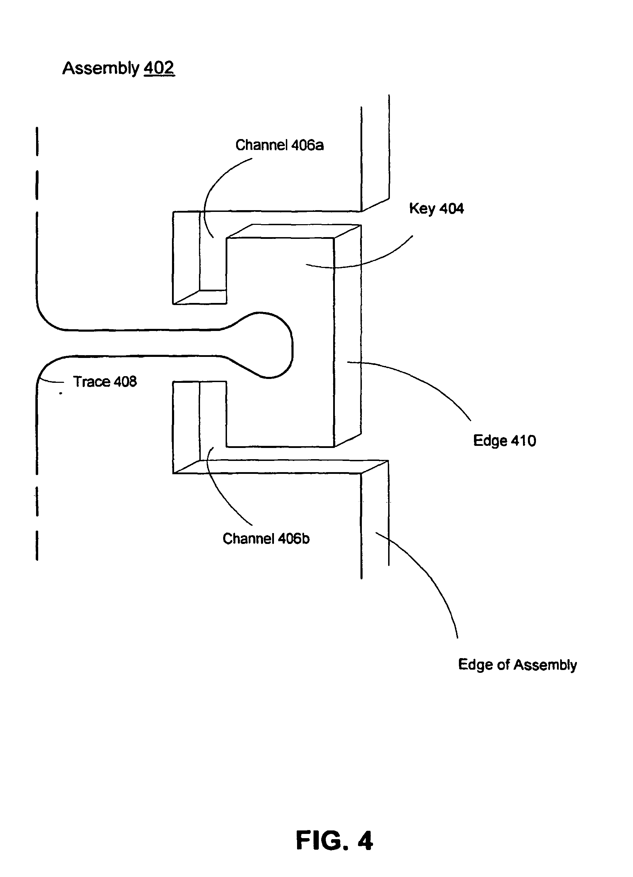

In FIG. 4, key 404 is defined by channels 406 in assembly 402. Edge 410 may be offset from an internal or external edge of the assembly, or may be flush with the assembly edge. In this and other embodiments, corners or edges of the key may be beveled to promote ease of handling and minimize the possibility of it catching or snagging on something.

In one embodiment of the invention, visual or optical inspection may be used to determine if a detachable key has been detached. Illustratively, an optical source or sensor may be configured to detect whether the key is in place.

The foregoing embodiments of the invention have been presented for purposes of illustration and description only. They are not intended to be exhaustive or to limit the invention to the forms disclosed. Accordingly, the scope of the invention is defined by the appended claims, not the preceding disclosure.

## Claims

1. A circuit board (102) comprising:
a mechanism (104) for provably disabling the circuit board;
a processing element;
signal means (106) for conducting a signal between the mechanism and the processing element; and
separation means (206) for facilitating detachment of the mechanism from the circuit board;
and **characterised in that** the processing element is programmed to test whether the mechanism has been detached from the circuit board, and if so, to render the circuit board at least partly non-functional.

2. The circuit board of claim 1, wherein the mechanism further comprises:
identification means (210) for identifying the mechanism.

3. The circuit board of claim 2, wherein said identification means comprises an identification circuit.

4. The circuit board of claim 3, wherein the identification circuit comprises a programmed identification code.

5. The circuit board of claim 3 or 4, wherein the identification circuit is encapsulated.

6. The circuit board of any of claims 3 to 5, wherein the identification circuit is readable after the mechanism is detached from the circuit board.

7. The circuit board of claim 2, wherein said identification means is protected from being easily manipulated.

8. The circuit board of claim 7, wherein the identification means is configured to be destroyed if an attempt is made to remove or tamper with the identification means.

9. The circuit board of any preceding claim, wherein the mechanism borders an edge of the circuit board, said edge being an internal edge defined by a bore through the circuit board.

10. The circuit board of any preceding claim, wherein said circuit board comprises a multi-layer assembly, and said signal means is formed on an inner layer of said multi-layer assembly.

11. A method for disabling a circuit board, comprising:
receiving a circuit board (102) for disablement, the circuit board comprising a detachable key (104) and a signal conductor configured (106) to convey a signal between said key and a processing element on the circuit board, wherein said key represents a portion of said circuit board;
detaching said key from the circuit board, wherein said circuit board further includes separation means (206) for facilitating detachment of the key from the circuit board; and
**characterised by** testing with the processing element to determine whether the key has been detached from the circuit board, and if so, rendering the circuit board at least partly non-functional.

12. The method of claim 11, wherein said key comprises an identification code.

13. The method of claim 12, wherein said identification code is a code programmed into an electronic identification module (210).

## Patentansprüche

1. Elektronikkarte (102), die aufweist:
einen Mechanismus (104) für das beweisbare Deaktivieren der Elektronikkarte,
ein Verarbeitungselement,
eine Signaleinrichtung (106) für das Leiten eines Signals zwischen dem Mechanismus und dem Verarbeitungselement, und
eine Trenneinrichtung (206) für das Erleichtern der Abtrennung des Mechanismus von der Elektronikkarte,
**dadurch gekennzeichnet, daß** das Verarbeitungselement programmiert ist, um zu testen, ob der Mechanismus von der Elektronikkarte abgetrennt wurde, und falls dies so ist, die Elektronikkarte zumindest teilweise nicht funktionsfähig zu machen.

2. Elektronikkarte nach Anspruch 1, bei der der Mechanismus weiterhin aufweist:
eine Identifizierungseinrichtung (210) für das Identifizieren des Mechanismus.

3. Elektronikkarte nach Anspruch 2, bei der die Identifizierungseinrichtung einen Identifikationsschaltkreis aufweist.

4. Elektronikkarte nach Anspruch 3, bei der der Identifizierungsschaltkreis einen programmierten Identifizierungscode aufweist.

5. Elektronikkarte nach Anspruch 3 oder 4, bei der der Identifizierungsschaltkreis eingekapselt ist.

6. Elektronikkarte nach einem der Ansprüche 3 bis 5, bei der der Identifikationsschaltkreis lesbar ist, nachdem der Mechanismus von der Elektronikkarte abgetrennt wurde.

7. Elektronikkarte nach Anspruch 2, bei der die Identifizierungseinrichtung davor geschützt ist, leicht manipuliert zu werden.

8. Elektronikkarte nach Anspruch 7, bei der die Identifizierungseinrichtung konfiguriert ist, so daß sie zerstört wird, wenn versucht wird, die ldentifikationseinrichtung zu entfernen oder zu verfälschen.

9. Elektronikkarte nach einem der vorherigen Ansprüche, bei der der Mechanismus an eine Kante der Elektronikkarte angrenzt, wobei die Kante eine innere Kante ist, die durch eine Bohrung durch die Elektronikkarte festgelegt wird.

10. Elektronikkarte nach einem der vorherigen Ansprüche, bei der die Elektronikkarte einen Mehrschichtaufbau aufweist und die Signaleinrichtung auf einer inneren Schicht des Mehrschichtaufbaus ausgebildet wird.

11. Verfahren zum Deaktivieren einer Elektronikkarte, das aufweist:
Empfangen einer Elektronikkarte (102) für die Deaktivierung, wobei die Elektronikkarte einen abtrennbaren Schlüssel (104) und einen Signalleiter aufweist, der konfiguriert (106) ist, um ein Signal zwischen dem Schlüssel und einem Verarbeitungselement auf der Elektronikkarte weiterzuleiten, wobei der Schlüssel einen Teil der Elektronikkarte darstellt,
Abtrennen des Schlüssels von der Elektronikkarte, wobei die Elektronikkarte weiterhin beinhaltet eine Trenneinrichtung (206) für das Erleichtern der Abtrennung des Schlüssels von der Elektronikkarte und
**gekennzeichnet ist durch** das Testen mit dem Verarbeitungselement, um zu bestimmen, ob der Schlüssel von der Elektronikkarte abgetrennt wurde, und falls dies so ist, zumindest teilweise nicht funktionsfähig machen der Elektronikkarte.

12. Verfahren nach Anspruch 11, bei dem der Schlüssel einen Identifikationscode aufweist.

13. Verfahren nach Anspruch 12, bei dem der Identifikationscode ein Code ist, der in ein elektronisches ldentifikationsmodul (210) programmiert ist.

## Revendications

1. Carte (102) à circuits comprenant :
un mécanisme (104) destiné à désactiver de façon indubitable la carte à circuits ;
un élément de traitement ;
un moyen (106) destiné à conduire un signal entre le mécanisme et l'élément de traitement ; et
un moyen (206) de séparation destiné à faciliter le détachement du mécanisme de la carte à circuits ;
et **caractérisée en ce que** l'élément de traitement est programmé pour tester si le mécanisme a été détaché de la carte à circuits, et s'il en est ainsi, pour rendre la carte à circuits au moins partiellement inutilisable.

2. Carte à circuits selon la revendication 1, dans laquelle le mécanisme comprend en outre :
un moyen (210) d'identification destiné à identifier le mécanisme.

3. Carte à circuits selon la revendication 2, dans laquelle ledit moyen d'identification comprend un circuit d'identification.

4. Carte à circuits selon la revendication 3, dans laquelle le circuit d'identification comprend un code programmé d'identification.

5. Carte à circuits selon la revendication 3 ou 4, dans laquelle le circuit d'identification est encapsulé.

6. Carte à circuits selon l'une quelconque des revendications 3 à 5, dans laquelle le circuit d'identification est lisible après que le mécanisme a été détaché de la carte à circuits.

7. Carte à circuits selon la revendication 2, dans laquelle ledit moyen d'identification est protégé pour n'être pas facilement manipulé.

8. Carte à circuits selon la revendication 7, dans laquelle le moyen d'identification est configuré pour être détruit si l'on tente de retirer ou de falsifier le moyen d'identification.

9. Carte à circuits selon l'une quelconque des revendications précédentes, dans laquelle le mécanisme touche un bord de la carte à circuits, ledit bord étant un bord interne défini par un trou traversant la carte à circuits.

10. Carte à circuits selon l'une quelconque des revendications précédentes, dans laquelle ladite carte à circuits comprend un assemblage multicouche, et ledit moyen conducteur de signal est formé sur une couche interne dudit assemblage multicouche.

11. Procédé de désactivation d'une carte à circuits, comprenant :
la réception d'une carte (102) à circuits pour désactivation, la carte à circuits comprenant une clé détachable (104) et un conducteur (106) de signal configuré pour transporter un signal entre ladite clé et un élément de traitement sur la carte à circuits, dans lequel ladite clé représente une partie de ladite carte à circuits ;
le détachement de ladite clé de la carte à circuits, dans lequel ladite carte à circuits comprend en outre un moyen (206) de séparation destiné à faciliter le détachement de la clé de la carte à circuits ; et
**caractérisé par** le test avec l'élément de traitement pour déterminer si la clé a été détachée de la carte à circuits, et s'il en est ainsi, pour rendre la carte à circuits au moins partiellement inutilisable.

12. Procédé selon la revendication 11, dans lequel ladite clé comprend un code d'identification.

13. Procédé selon la revendication 12, dans lequel ledit code d'identification est un code programmé dans un module électronique (210) d'identification.
